# EUROPÄISCHE PATENTSCHRIFT

(11) **EP 0 852 759 B1**
(45) Veröffentlichungstag und Bekanntmachung des Hinweises auf die Patenterteilung: **20.03.2002**
(21) Anmeldenummer: 96941579.3
(22) Anmeldetag: 25.09.1996
(51) Int. Cl.: G05B 17/02, G05B 23/02

(54) **ENTWURFSVERFAHREN FÜR DIE ANLAGENTECHNIK UND RECHNERGESTÜTZTES PROJEKTIERUNGSSYSTEM ZUR VERWENDUNG BEI DIESEM VERFAHREN**
DRAFTING METHOD FOR INDUSTRIAL AND BUILDING SYSTEMS AND COMPUTER-CONTROLLED PLANNING SYSTEM FOR USE IN SAID METHOD
PROCEDE DE CONCEPTION POUR SYSTEMES INDUSTRIELS ET SYSTEMES DE CONSTRUCTION, ET SYSTEME DE PLANIFICATION ASSISTE PAR ORDINATEUR A UTILISER DANS LE CADRE DUDIT PROCEDE

(30) Priorität: 25.09.1995 DE 19535549
(43) Veröffentlichungstag der Anmeldung: 15.07.1998
(73) Patentinhaber: SIEMENS AKTIENGESELLSCHAFT, 80333 München (DE)
(72) Erfinder: SONST, Horst, D-91093 Hessdorf (DE); FISCHER, Horst, D-90475 Nürnberg (DE); LÖWEN, Ulrich, D-91052 Erlangen (DE); FREITAG, Hartmut, D-91230 Happurg (DE); WEHN, Norbert, D-85579 Neubiberg (DE); ROSEN, Roland, D-82211 Herrsching (DE)
(86) Internationale Anmeldenummer: DE9601815
(87) Internationale Veröffentlichungsnummer: WO9712301

(56) Entgegenhaltungen:
- EP-A- 0 524 344
- WO-A-94/12914
- DE-A- 4 203 432
- US-A- 4 965 743
- JOURNAL OF PARALLEL AND DISTRIBUTED COMPUTING, Bd. 15, Nr. 2, 1.Juni 1992, Seiten 90-102, XP000275612 KARSAI G ET AL: "MODEL-BASED INTELLIGENT PROCESS CONTROL FOR COGENERATOR PLANTS"
- COMPUTERS IN INDUSTRY, Bd. 18, Nr. 2, 1.Februar 1992, Seiten 135-144, XP000258301 BARNIKOW A ET AL: "DICTUM: DECISION SUPPORT SYSTEM FOR ANALYSIS AND SYNTHESIS OF LARGE -SCALE INDUSTRIAL SYSTEMS PART I: COMPONENTS"
- 1992 IEEE SYMPOSIUM ON COMPUTER AIDED CONTROL SYSTEM DESIGN, 17.März 1992, USA, Seiten 165-172, XP000616816 B.NILSSON: "OBJECT-ORIENTED CHEMICAL PROCESS MODELLING IN OMOLA"

## Beschreibung

Die Erfindung bezieht sich auf ein Verfahren zum Entwerfen von Modellen in der Anlagentechnik, bei der Industrieanlagen automatisiert werden, wobei die Technologie der Anlage durch Prozeßtechnik einerseits und durch Leittechnik andererseits beschrieben wird. Daneben bezieht sich die Erfindung auch auf ein rechnergestütztes Projektierungssystem zur Durchführung dieses Verfahrens, enthaltend einen Digitalrechner mit Zentraleinheit, Arbeits-, Programm- und Datenspeichern und mit Mitteln zur Codegenerierung.

Unter Anlagentechnik wird im allgemeinen Aufbau, Betreiben und Wartung von Industriebetrieben verstanden. Die technischen Anlagen von Industriebetrieben werden durch die Prozeßtechnik einerseits und die Leittechnik andererseits bestimmt, was bei der Automatisierung solcher Industrieanlagen berücksichtigt werden muß.

Aus der WO-A-94/12914 ist ein Verfahren zum Erstellen einer anwendungsabhängigen Logik eines frei programmierten Schaltwerkes bekannt, bei der aus der Spezifikation automatisch ein Code für die zu verwendenden Automatisierungssysteme erzeugt wird. Weiterhin ist aus "Journal of Parallel and Discributed Computing", 15 (1992), June No. 2, page 90 ff. eine Methode für das Design und die Implementierung von Monitoring- und Diagnostiksystemen vorgeschlagen, bei denen unter Verwendung von Datenbanken Modelle erstellt werden, welche mittels geeigneter Software weiterverwendbar sind. In entsprechender Weise geht es bei der Veröffentlichung aus "1992 IEEE Symposium on Computer Aided Control System Design" darum, softwaremäßige Tools zur Modellierung von verfahrenstechnischen Prozessen einzusetzen. Damit sollen die Prozesse und deren Steuerung nachgebildet werden, wobei bereits objektorientierte Modelle verwendet und auf dem Bildschirm eines Monitors angezeigt werden.

Dagegen geht es bei der EP-A-0 524 344 um eine Steuerung für Werkzeugmaschinen, die durch eine Vielzahl einzelner Funktionsobjekte realisiert werden soll. Zur Erstellung der Funktionsobjekte wird dort bereits ein objektorientierter Ansatz verwendet. Schließlich ist aus der DE-A-42 03 432 ein Verfahren zur Überwachung technischer Prozesse oder technischer Anlagen bekannt, wobei die den Prozeß oder die Anlage beschreibenden Prozeß- oder Anlagenparameter in Objekten einer dynamischen, objektorientierten Datenbank gespeichert werden. Von dort sind sie zur Verwendung in der Automatisierungstechnik abrufbar.

In allen Fällen der abgehandelten Druckschriften geht es also im weitesten Zusammenhang um die Automatisierung einer in einem Industriebetrieb vorhandenen technischen Anlage.

Bei der Planung der Automatisierung kompletter Industrieanlagen wird bisher im allgemeinen von einer vorgegebenen Prozeßtechnik ausgegangen, zu welcher eine zugehörige Leittechnik entwickelt werden muß, was üblicherweise von einem Elektrotechniker als Projekteur durchgeführt wird.

Eine wesentliche Aufgabe bei der Konzeption der Leittechnik einer Anlage ist zunächst einmal eine Aufgabenklärung, die zusammen mit dem späteren Betreiber der Anlage erfolgen muß. Wesentlich ist dabei die Erstellung einer externen Spezifikation, welche die Anforderungen an die zu projektierende Leittechnik beschreibt. Üblich ist heutzutage, daß dazu ein Technologe mit dem Projekteur zusammenarbeitet. Als Ergebnis entstehen dabei Funktionspläne, d.h. eine Beschreibung der zu lösenden Projektierungsaufgabe aus der Sicht des Elektrotechnikers.

Bei der Umsetzung solcher Funktionspläne in eine weiterbearbeitbare softwaremäßige Lösung gibt es jedoch häufig Probleme, weil Diskrepanzen zwischen externer Spezifikation und der fertigen Lösung entstehen.

Aufgabe der Erfindung ist es daher, die bisher bekannten Entwurfsverfahren für die Anlagentechnik zu verbessern und zugehörige Werkzeuge zu schaffen.

Die Aufgabe wird erfindungsgemäß durch folgende Maßnahmen gelöst:
- Es werden aus Modellen der Prozesse und der Leittechnik verfahrenstechnische Objekte gebildet,
- die verfahrenstechnischen Objekte werden in einem rechnergestützten Projektierungssystem verarbeitet,
- im Projektierungssystem werden mit Hilfe der verfahrenstechnischen Objekte ineinander verzahnte Modelle erzeugt, die aus Steuerung und/oder Regelung und/oder Simulation, einschließlich Störungsanalyse und den Prozeßmodellen, bestehen.
Bei der Erfindung ist das Verfahrensergebnis als Software und/oder als Hardware ausführbar. Wesentlich ist, daß zur Beschreibung der Anlage jeweils rechnergestützt die Modelle des Prozesses und der Leittechnik in einem Anlagenmodell zusammengefaßt und daraus automatisiert ineinander verzahnte Modelle erstellt werden.

Im Rahmen der Erfindung werden jeweils anwendungsneutrale Beschreibungsmittel gewählt. Insbesondere kommt es darauf an, die Spezifikation so technologienah zu wählen, daß die verfahrenstechnische Lösung erkennbar ist, wobei die Funktionsbeschreibung der Strukturbeschreibung untergeordnet ist. Solche Spezifikationen können dann formal analysiert und simulativ validiert werden. Damit ist es möglich, unmittelbar aus der Spezifikation einen Code für das im Rahmen des Projektierungssystem zu verwendende Automatisierungsgerät zu erzeugen.

Besonders vorteilhaft ist beim erfindungsgemäßen Verfahren, daß die bei der Projektierung entwickelten Modelle anschließend unmittelbar bei der Anlagenrealisierung verwendet werden. Im Ergebnis ergibt sich dadurch ein wesentliches Einsparpotential.

Bei einem geeigneten Projektierungssystem der eingangs genannten Art sind Mittel zur Bildung von verzahnten Modellen, bestehend aus Steuerung und/oder Regelung und/oder Simulation einschließlich Störungsanalyse und den Prozeßmodellen, vorhanden, wozu der Digitalrechner gleichermaßen einen Zugriff auf eine Bibliothek von verfahrenstechnischen Komponententypen und auf eine Beschreibung der Elemente der konkreten Anlage hat. Vorzugsweise hat die Komponentenbibliothek eine branchenspezifische Auslegung.

Mit dem erfindungsgemäßen Projektierungssystem ist also ein Werkzeug geschaffen, bei dem die Komponententypen aus der Sicht des Technologen definiert sind und ein unmittelbarer Bezug zur Prozeßtechnik besteht.

Die Erfindung wurde beispielhaft im Rahmen der Papiertechnologie untersucht und es wurde ein Demonstrator für eine Altpapieraufbereitung erstellt. Darüber hinaus konnte gezeigt werden, daß die erzielten Ergebnisse auf andere Bereiche der Anlagentechnik verallgemeinerbar sind.

Weitere Einzelheiten und Vorteile der Erfindung ergeben sich aus der nachfolgenden Figurenbeschreibung von Ausführungsbeispielen anhand der Zeichnung. Es zeigen jeweils als Prinzipdarstellung
- Figur 1: das neue Entwurfsverfahren,
- Figur 2: das zugehörige Projektierungssystem,
- Figur 3: der hierarchische Aufbau der dabei als Komponententypen verwendeten verfahrenstechnischen Elemente,
- Figur 4: die Beschreibung einer Anlage mit dem Projektierungssystem,
- Figur 5: die dabei verwendete Methode zur automatischen Codegenerierung und
- Figur 6: das Vorgehen bei der Fehlerdiagnose.

Unter einer Anlage versteht man im allgemeinen die Gesamtheit der Ausrüstungen eines Betriebs, die zur Produktion, zur Fertigung, zur Energieerzeugung und/oder zu Förder- bzw. Transportzwecken erforderlich sind. Im Nachfolgenden werden unter dem Begriff "Industrieanlage" überwiegend Großanlagen wie beispielsweise Kraftwerke, Müllverbrennungsanlagen oder auch Papierfabriken verstanden.

Zur Erstellung einer Anlage müssen unterschiedliche Partner zusammenwirken: Dies ist einmal der Betreiber, dessen Ziel es ist, durch das Anbieten von Dienstleistungen bzw. Produkten ein Ergebnis zu erzielen. Dazu orientiert er sich an den Bedürfnissen des Marktes. Er formuliert seine Ziele mit Hilfe von Begriffen wie Durchsatz, Kosten, Qualität und/oder Produktivität.

Vom Betreiber der künftigen Anlage nehmen üblicherweise Téchnologen die Anforderungen entgegen und setzen sie um in einen Entwurf für eine Anlagenkonfiguration. Technologen benötigen dabei Wissen über notwendige Verfahrensschritte, da sie für die Auslegung der verschiedenen Anlagenteile zuständig sind. Als Ergebnis erzeugen die Technologen ein Technologieschema, in dem die einzelnen Maschinen, Sensoren, Stellglieder, aber auch Material-, Wirk- und Informationsflüsse festgelegt sind.

Da für gewisse Verfahrensschritte der Anlage Einzellösungen in Form von Maschinen und Ausrüstungen, die von Komponentenlieferanten angeboten werden, bereits vorhanden sind, ist es zweckmäßig, zwischen Lieferanten für die Prozeßtechnik und Lieferanten für die Leittechnik zu unterscheiden. Üblicherweise erstellen Systemintegratoren aus den einzelnen Komponenten der Komponentenlieferanten die komplette Anlage.

Wesentlich für ein erfolgreiches Entwurfsverfahren sowie die weitere Erstellung bei der Anlagentechnik ist die technologische Kompetenz, welche für die Leittechnik einerseits und für die Prozeßtechnik andererseits maßgebend ist. Die Leittechnik umfaßt dabei alle Einrichtungen, die zum automatischen Betrieb der Anlage notwendig sind. Dazu gehören beispielsweise unter anderem die Aktoren und Sensoren, die Hard- und Software der Automatisierungsebene und die Komponenten der Leit- und Führungstechnik der Anlage. Die eigentliche Prozeßtechnik wird dagegen durch Aggregate, Pumpen, Ventile u. dgl. beschrieben.

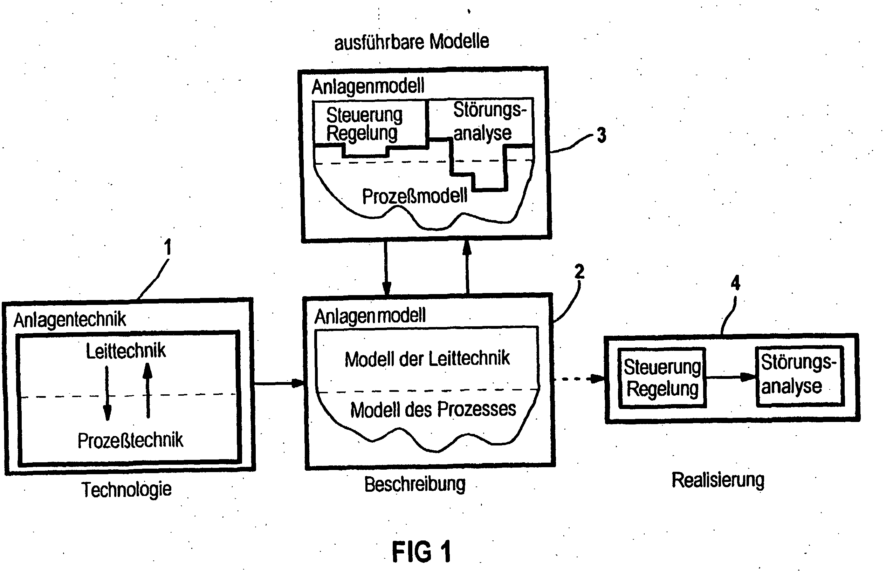

In Figur 1 geht der Block von der bekannten Technologie einer zu projektierenden Anlage aus. Für die Anlagentechnik ist dabei sowohl die Leittechnik als auch die Prozeßtechnik von Bedeutung, welche miteinander in Wechselwirkung stehen. Anhand von Block 2 wird die zugehörige Beschreibung verdeutlicht: Das Anlagenmodell besteht dabei einerseits aus einem Modell der Leittechnik und andererseits aus einem Modell des Prozesses, welche zumindest einmal voneinander zu trennen sind. Im Block 3 sind die ausführbaren Modelle eingetragen. die im einzelnen miteinander verzahnt sind. Dabei verdeutlicht die Verzahnung, daß nunmehr erstmalig die bisher üblichen Abgrenzungen aufgehoben sind. Insbesondere, die Teilmodelle greifen jeweils auf solche Informationen, die in anderen Teilmodellen bereits beschrieben sind, zurück. Eine doppelte Beschreibung unterbleibt also, was insbesondere bei einer im allgemeinen immer notwendigen Störungsanalyse Vorteile hat.

Gemäß Figur 1 sind dem Prozeßmodell entsprechende Einheiten zur Steuerung und/oder Regelung und/oder Simulation einerseits sowie zur Störungsanalyse andererseits zugeordnet. Schließlich umfaßt der Block 4 die spätere Realisierung der Anlage mit entsprechender Störungsanalyse.

Bei der Vorgehensweise entsprechend Figur 1 ist die Basis des Entwurfsverfahrens eine technologiennahe Beschreibung der Struktur einer Anlage und deren Funktionsweise. Durch die Kombination von Techniken zum Entwurf von Steuerungen und Regelungen, zur Simulation und zur Diagnose wird ein ausführbares Anlagenmodell erstellt, das den Spezifikationen entspricht.

Die Spezifikation für das Anlagenmodell kann anschließend im einzelnen formal analysiert und simulativ validiert werden, d.h. durch Simulationsrechnungen bestätigt werden. Die Simulation erfolgt mit graphischer Unterstützung, um gemeinsam dem Technologen die Aufgabenklärung zu verdeutlichen und ggfs. die Spezifikation zu modifizieren. Die validierte Spezifikation wird dahingehend genutzt, daß daraus weitestgehend automatisch ein Code für Automatisierungssysteme erzeugt werden kann, was im einzelnen in der europäischen Patentveröffentlichung EP-A-0 671 027 für spezifische Anwendungszwecke bei der Bahntechnik beschrieben ist.

Ein System zur Verwendung bei einer Vorgehensweise gemäß Figur 1 beinhaltet eine technologiennahe Beschreibung der betreffenden Anlage. Dabei setzt sich die konkrete Anlage zusammen aus Objekten der Komponentenbibliothek und wird so auf die abzubildende Anlage über Parameter und Wechselbeziehungen eingestellt. Wichtig ist, daß die Komponententypen aus der Sicht des Technologen definiert wurden, so daß nunmehr ein unmittelbarer Bezug zur Prozeßtechnik möglich ist. Für die einzelnen Komponententypen wird die Struktur gemeinsam für alle Anteile der Entwurfsverfahren und das Verhalten unter den Aspekten Steuerung und Regelung, Prozeßsimulation und Störungsanalyse spezifiziert. Die Komponenten der konkreten Anlage erhält man daraus durch Instanziierung der Komponententypen.

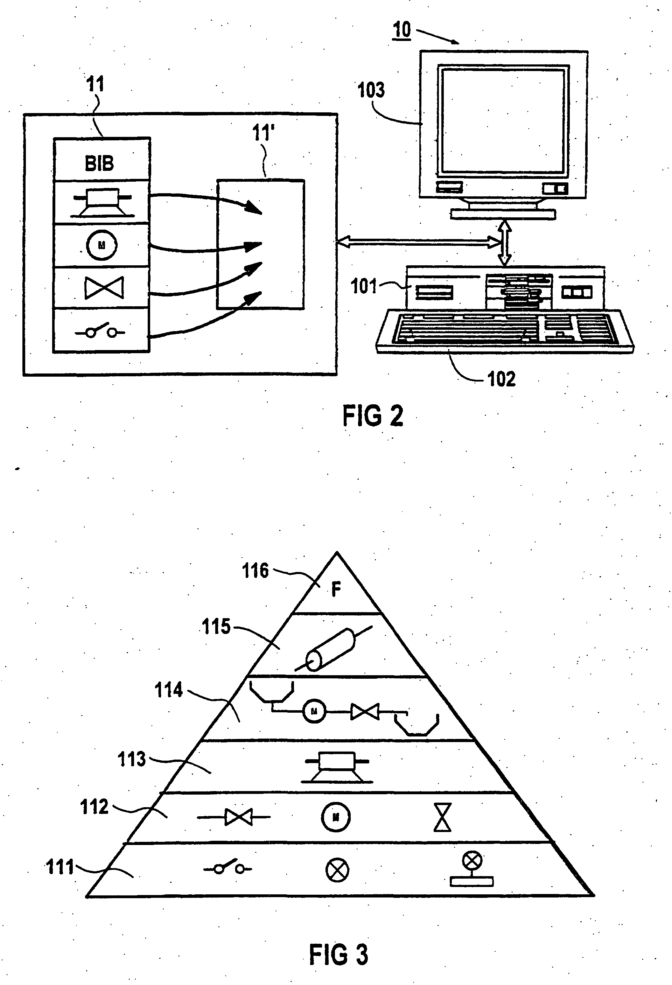

In Figur 2 kennnzeichnet 10 einen üblichen Digitalrechner mit Zentraleinheit 101, Eingabeeinheit 102 und Monitor 103. Die Zentraleinheit 101 beinhaltet u.a. Arbeits-, Programm- und Datenspeicher, die nicht im einzelnen dargestellt sind. Wesentlich ist im vorliegenden Zusammenhang, daß im Datenspeicher eine Komponententypbibliothek 11 von verfahrenstechnischen Elementen vorhanden ist, die sich zu komplexeren Objekten kombinieren lassen. Letzteres ist in Figur 2 durch den separaten Block 11, der mit der Zentraleinheit 101 bzw. dem Monitor 103 verbunden ist, angedeutet. Durch Instanziierung einzelner Elemente lassen sich im Bereich 11' solche Objekte als Modelle bilden und unmittelbar auf dem Monitor 103 darstellen.

In Figur 3 ist verdeutlicht, daß die Komponentenbibliothek 12 einen hierarchischen Aufbau hat. Beispielsweise sind in einer untersten Ebene 111 Sensoren und Aktoren vorhanden und in der nächsten Ebene 112 Ventile und Motoren als sog.Typicals. In den darüberliegenden Ebenen 113 bis 116 folgen komplexere Komponenten sowie Teilanlagen, Anlagen und die Fabrik als komplette Industrieanlage. Solche Objekte können vom Benutzer unmittelbar abgerufen werden.

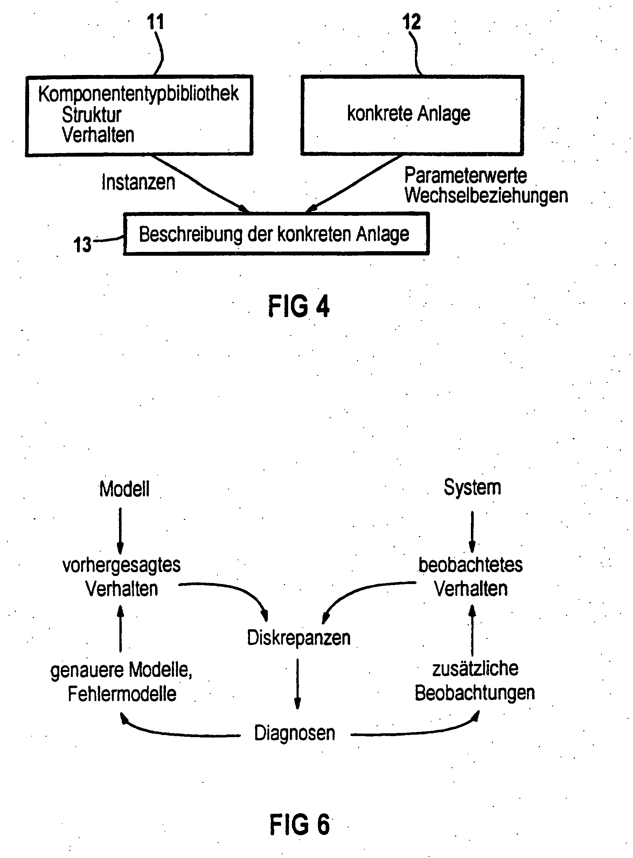

In Figur 4 stellt Block 11 eine solche Komponentenbibliothek dar, die branchenspezifisch strukturiert ist, und Block 12 eine zugehörige zu projektierende Industrieanlage. Die Beschreibung der konkreten Anlage 12 entsprechend der Vorgehensweise gemäß Figur 1 erfolgt durch Instanziierung der Komponenten aus der Komponentenbibliothek 11. Durch Hinzufügen der Parameterwerte mit entsprechenden Wechselbeziehungen der Anlage 12 läßt sich die Beschreibung selbst realisieren. Durch die Berücksichtigung der Anlagenstruktur wird dabei für die einzelnen Anteile des Entwurfsverfahrens das globale Verhalten der Anlage aus den lokalen Beschreibungen automatisch konstruiert.

Die Codegenerierung für die Steuerung und Regelung einer zu projektierenden Anlage kann entweder unmittelbar auf der Beschreibung der Anlage aufsetzen oder alternativ auf dem ausführbaren Modell der Steuerung und Regelung basieren. Gemäß letzterer Alternative ist es dafür erforderlich, daß die Steuerungs- und Regelungsvorgänge explizit deterministisch beschrieben sind. Es wird in diesem Fall von einer alternativen Codegenerierung gesprochen.

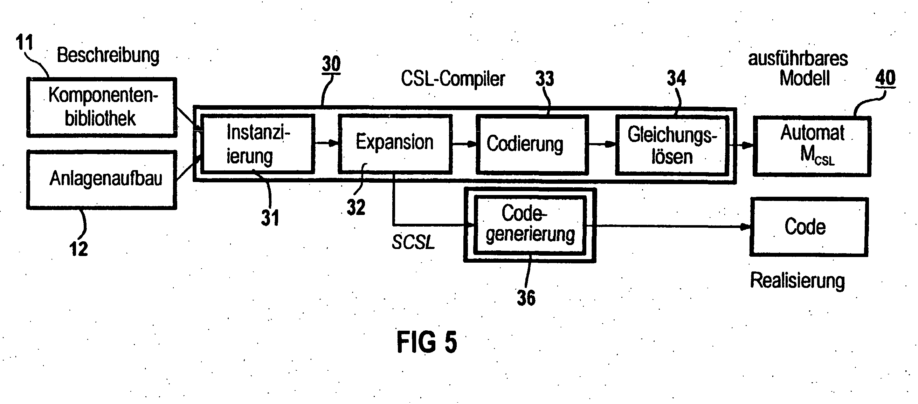

Die alternative Codegenerierung nutzt gewisse Phasen eines bekannten CSL-Compilers, in dem sie nicht auf der bekannten Sprache CSL, sondern auf der Sprache SCSL aufsetzt. Es wird dabei nicht der volle Umfang der Sprache SCSL von der alternativen Codegenerierung berücksichtigt. Hierzu ist in Figur 5 ein sogenannter CSL-Compiler 30 dargestellt, dem aus Figur 1 bis Figur 4 die Blöcke der Komponentenbibliothek 11 und des konkreten Anlagenaufbaus 12 zugeordnet sind. Der CSL-Compiler 30 besteht aus den Einheiten 31 für die Instantiierung, 32 für die sogenannte Expansion, 33 für die Codierung und 34 für das Gleichungslösen, mit denen ein Automat 40 generiert wird. Bei der alternativen Codegenerierung wird an der Einheit 32 abgegriffen und über die SCSL-Sprache in der Einheit 36 zur Codegenerierung der tatsächliche Code realisiert.

Bei der Sprache SCSL wird also vom CSL-Compiler 30 ein Zwischenergebnis ausgenutzt, das nach der Expansion erzeugt wird. Als Zielsprache wird bei der Codegenerierung ein zielmaschinenunabhängiger Zwischencode erzeugt, der der Norm IEEC 1131-3 entspricht.

Das an den Prinzipschaubildern gemäß Figuren 1 und 3 erläuterte Verfahren geht aus von Verfahren zur Beschreibung und Analyse zustandsähnlicher Systeme. Dieses Verfahren ermöglicht die Konstruktion der Steuerung und Regelung einer hierarchisch aufgebauten Anlage aus der Strukturbeschreibung und der Beschreibung lokaler Steuerungs- und Regelungsvorgänge. Damit werden die Inkonsistenzen zwischen den unterschiedlichen lokalen Anforderungen automatisch aufgedeckt. Die Regelungsaufgaben sind dagegen weitgehend entkoppelt, so daß eine Trennung in analoge und diskrete Zusammenhänge möglich ist.

Für eine simulative Validation der Steuerung- und Regelungsvorgänge wird das Verhalten von Prozeß, Sensorik und Aktorik in Form eines Simulationsmodelles beschrieben. Das Gesamtverhalten der Anlage wird auch hier durch eine Kombination lokaler Modelle unter Berücksichtigung der Strukturbeschreibung konstruiert. Für die Validation des Diagnoseanteils werden zusätzlich mögliche Fehlerfälle von Komponenten modelliert.

Zur Analyse von Störungen, die durch Anlagenfehler hervorgerufen werden, lassen sich Verfahren der modellbasierten Diagnose verwenden. Dafür wird die Kombination lokaler Modelle des Normal- und Fehlverhaltens von Komponenten entsprechend der Anlagenstruktur zur Erkennung und Identifikation von Fehlern benutzt. Für eine engere Integration von Steuerungsentwurf und Diagnosetechnik sind Konzepte zur Fehlererkennung durch die Steuerung und Analyse des Steuerungszustandes bekannt.

Aus Figur 6 ergibt sich im wesentlichen selbsterklärender Weise, wie die Diagnose durch Finden und Analyse von Diskrepanzen erfolgen kann. Dabei wird davon ausgegangen, daß die Erkennung des Zielverhaltens eines technischen Systems die Bestimmung plausibler Erläuterungen für das beobachtete Fehlverhalten, d.h. die Diagnose, für die Wiederherstellung seiner ursprünglichen Funktion entscheidend ist. Die Diagnose setzt dabei das Wissen über das normale erwartete Verhalten des Systems voraus.

Bei der modellbasierten Diagnose gemäß Figur 4 wird von einem expliziten Modell des zu diagnostizierenden Systems ausgegangen. Dies Modell umfaßt eine Beschreibung der Struktur des Systems, d.h. der Komponenten und ihrer Verbindungen, sowie lokale, d.h. kontextfreie Beschreibungen des Verhaltens einzelner Komponenten. Es werden im wesentlichen qualitative Modelle verwendet, um den Modellierungsprozeß zu vereinfachen.

Auf der Basis einer solchen Systembeschreibung wird unter der Annahme, daß jede Komponente sich korrekt verhält, das Verhalten des Gesamtsystems vorhergesagt und dabei protokolliert, von welchen Korrektheitsannahmen bestimmte Aspekte dieses Verhaltens abhängen. Treten Diskrepanzen zwischen vorhergesagtem und beobachtetem Verhalten auf, werden die protokollierten Abhängigkeiten verwendet, um die Mengen von Korrekturannahmen zu identifizieren, die für die Diskrepanzen verantwortlich ist. Diese Mengen von inkonsistenen Annahmen werden auch Konflikte genannt. Um alle Konflikte aufzulösen, muß eine Diagnose mindestens eine Annahme aus jedem Konflikt zurückziehen. Auf diese Weise erhält man im allgemeinen mehrere Diagnosen, die sich durch genauere Modelle und zusätzliche Beobachtungen weiter modifizieren lassen.

## Patentansprüche

1. Verfahren zum Entwerfen von Modellen in der Anlagentechnik, bei der Industrieanlagen automatisiert werden, wobei die Technologie der Anlage durch Prozeßtechnik einerseits und durch Leittechnik andererseits beschrieben wird, g e**kennzeichnet** durch folgende Maßnahmen:
- Es werden aus Modellen der Prozesse und der Leittechnik verfahrenstechnische Objekte gebildet,
- die gebildeten verfahrenstechnischen Objekte werden in einem rechnergestützten Projektierungssystem verarbeitet,
- im Projektierungssystem werden mit Hilfe der gebildeten verfahrenstechnischen Objekte ineinander verzahnte Modelle gebildet, die aus Steuerung und/oder Regelung und/oder Simulation, einschließlich Störungsanalyse und den Prozeßmodellen, bestehen.

2. Verfahren nach Anspruch 1, **dadurch gekennzeichnet, daß** das Verfahrensergebnis als Software und/oder als Hardware realisierbar ist.

3. Verfahren nach Anspruch 1, wobei eine externe Spezifikation vorgegeben ist, **dadurch gekennzeichzeichnet**, **daß** die Spezifikation technologienah gewählt wird, so daß sich solche verfahrenstechnische Objekte ergeben, bei denen die Funktionsbeschreibung der Strukturbeschreibung untergeordnet ist.

4. Verfahren nach Anspruch 3, **dadurch gekennzeichnet, daß** die Spezifikation formal analysiert und simulativ validiert wird.

5. Verfahren nach Anspruch 4, **dadurch gekennzeichnet, daß** aus der Spezifikation ein zielmaschinenneutraler Code für Automatisierungssysteme erzeugt wird.

6. Verfahren nach Anspruch 1, **dadurch gekennzeichnet, daß** zur Benutzungsanalyse eine modell-basierte Diagnose durchgeführt wird.

7. Verfahren nach Anspruch 6, **dadurch gekennzeichnet, daß** bei der modellbasierten Diagnose eine Kombination lokaler Modelle angewandt wird.

8. Verfahren nach Anspruch 6 und 7, **dadurch gekennzeichnet, daß** bei Störungen, die durch Anlagenfehler hervorgerufen werden, Modelle des Normal- und Fehlverhaltens von Komponenten entsprechend der Anlagenstruktur herangezogen werden.

9. Verfahren nach Anspruch 8, **dadurch gekennzeichnet, daß** die Diagnosetechniken in den Anlagenentwurf integriert sind.

10. Rechnergestütztes Projektierungssystem zur Durchführung des Verfahrens nach Anspruch 1 oder einem der Ansprüche 2 bis 9, enthaltend einen Digitalrechner mit Zentraleinheit, Arbeits-, Programm- und Datenspeichern und mit Mitteln zur Codegenerierung, **dadurch gekennzeichnet, daß** Mittel zur Bildung von verfahrenstechnischen Objekten vorhanden sind und daß die gebildeten verfahrenstechnischen Objekte in einem rechnergestützten Projektierungssystem derart verarbeitbar sind, daß ineinander verzahnte Modelle gebildet werden, die aus Steuerung und/oder Regelung und/oder Simulation, einschließlich Störungsanalyse und den Prozeßmodellen, bestehen, wozu der Digitalrechner gleichermaßen einen Zugriff auf eine Bibliothek (11) von verfahrenstechnischen Komponententypen und auf eine Beschreibung (13) der Elemente der konkreten Anlage (12) hat.

11. Projektierungssystem nach Anspruch 10, **dadurch gekennzeichnet, daß** die Komponentenbibliothek (11) Bestanteil des Datenspeichers ist.

12. Projektierungssystem nach Anspruch 11, **dadurch gekennzeichnet, daß** die verfahrenstechnischen Komponententypen einen hierarchischen Aufbau bilden.

13. Projektierungssystem nach Anspruch 10, **dadurch gekennzeichnet, daß** die Bibliothek (11) der verfahrenstechnischen Komponententypen eine branchenspezifische Ausprägung hat.

14. Projektierungssystem nach Anspruch 10, **dadurch gekennzeichnet, daß** die verfahrenstechnischen Komponententypen aus der Sicht eines Technologen definiert sind und ein unmittelbarer Bezug zur Prozeßtechnik besteht.

15. Projektierungssystem nach Anspruch 14, **dadurch gekennzeichnet, daß** das Verhalten der verfahrenstechnischen Komponententypen hinsichtlich Steuerung und/oder Regelung, Prozeßsimulation und Störungsanalyse spezifiziert ist.

16. Projektierungssystem nach Anspruch 10, **dadurch gekennzeichnet, daß** für eine konkrete Anlage (12) durch Instanziierung der Verfahrenstechnischen Komponententypen der Anlagenaufbau realisiert ist.

17. Projektierungssystem nach Anspruch 10, **dadurch gekennzeichnet, daß** die Mittel zur Codegenerierung im Programmspeicher des Rechners geladen sind und automatisiert arbeiten.

18. Projektierungssystem nach Anspruch 17, **dadurch gekennzeichnet, daß** ein CSL-Compiler (30) vorhanden ist, der zur Codegenerierung genutzt wird.

## Claims

1. Method of drafting models in plant engineering in which industrial plants are automated, wherein the technology of the plant is described, on the one hand, by process technology and, on the other hand, by control and instrumentation technology, **characterized by** the following measures:
- industrial engineering objects are formed from models of the processes and control and instrumentation technology,
- the industrial engineering objects formed are processed in a computer-aided designing system,
- in the designing system, mutually interlocked models that comprise control and/or regulation and/or simulation, including breakdown analysis and the process models, are formed with the aid of the industrial engineering objects formed.

2. Method according to Claim 1, **characterized in that** the result of the method can be implemented as software and/or as hardware.

3. Method according to Claim 1, wherein an external specification is provided, **characterized in that** the chosen specification is technologically realistic so that those industrial engineering objects result for which the functional description is subordinate to the structure description.

4. Method according to Claim 3, **characterized in that** the specification is analysed formally and simulatively validated.

5. Method according to Claim 4, **characterized in that** a target machine-neutral code for automation systems is generated from the specification.

6. Method according to Claim 1, **characterized in that** a model-based diagnosis is carried out for the purpose of use analysis.

7. Method according to Claim 6, **characterized in that** a combination of local models is used in the model-based diagnosis.

8. Method according to Claims 6 and 7, **characterized in that**, in the event of breakdowns due to plant faults, models of the normal behaviour and fault behaviour of components in accordance with the plant structure are used.

9. Method according to Claim 8, **characterized in that** the diagnosis technologies are integrated in the plant draft.

10. Computer-aided designing system for carrying out the method according to Claim 1 or one of Claims 2 to 9, comprising a digital computer with central unit, main memory, program memory and data memory and with means for code generation, **characterized in that** means are available for forming industrial engineering objects and **in that** the industrial engineering objects formed can be processed in a computer-aided designing system in such a way that mutually interlocked models are formed that comprise control and/or regulation and/or simulation, including breakdown analysis and the process models, for which purpose the digital computer equally has access to a library (11) of industrial engineering component types and to a description (13) of the elements of the specific plant (12).

11. Designing system according to Claim 10, **characterized in that** the component library (11) is a constituent of the data memory.

12. Designing system according to Claim 11, **characterized in that** the industrial engineering component types form a hierarchical structure.

13. Designing system according to Claim 10, **characterized in that** the library (11) of the industrial engineering component types is of an industry-specific nature.

14. Designing system according to Claim 10, **characterized in that** the industrial engineering component types are defined from the point of view of a technologist and a direct relationship exists to the process technology.

15. Designing system according to Claim 14, **characterized in that** the behaviour of the industrial engineering component types is specified with regard to control and/or regulation, process simulation and breakdown analysis.

16. Designing system according to Claim 10, **characterized in that** the plant structure is implemented for a specific plant (12) by instantiating the industrial engineering component types of the plant structure.

17. Designing system according to Claim 10, **characterized in that** the means for code generation are loaded in the program memory of the computer and operate in an automated manner.

18. Designing system according to Claim 17, **characterized in that** a CSL compiler (30) is available and is used for code generation.

## Revendications

1. Procédé pour concevoir des modèles dans la technique des installations, dans laquelle les installations industrielles sont automatisées, la technologie de l'installation étant décrite d'une part par la technique des processus industriels et d'autre part par la technique de contrôle, **caractérisé par** les dispositions suivantes :
- des objets de la technologie des procédés industriels sont formés à partir de modèles des processus et de la technique de commande,
- les objets de la technologie des procédés industriels sont traités dans un système de planification assisté par ordinateur,
- dans le système de planification il est généré des modèles imbriqués à l'aide d'objets de la technologie des procédés industriels, lesquels modèles consistent en la commande et/ou la régulation et/ou la simulation, y compris l'analyse des perturbations et des modèles de processus.

2. Procédé selon la revendication 1, **caractérisé en ce que** le résultat du procédé est réalisable par logiciel et/ou par matériel.

3. Procédé selon la revendication 1, dans lequel une spécification externe est prédéterminée, **caractérisé en ce que** la spécification est choisie de manière à être proche de la technologie de telle sorte qu'il en résulte des objets de procédés dans lesquels la définition fonctionnelle est subordonnée à la description structurelle.

4. Procédé selon la revendication 3, **caractérisé en ce que** la spécification est analysée de façon formelle et est validée par simulation.

5. Procédé selon la revendication 4, **caractérisé en ce qu'**un code neutre vis-à-vis de la machine cible est généré à partir de la spécification pour le système d'automatisation.

6. Procédé selon la revendication 1, **caractérisé en ce qu'**un diagnostic fondé sur des modèles est effectué en vue de l'analyse de l'utilisation.

7. Procédé selon la revendication 6, **caractérisé en ce qu'**une combinaison de modèles locaux est utilisée dans le diagnostic fondé sur des modèles.

8. Procédé selon la revendication 6 et 7, **caractérisé en ce que** lors de perturbations, qui sont causées par des défauts de l'installation, il est utilisé des modèles du comportement normal et du comportement anormal des composants correspondant à la structure de l'installation.

9. Procédé selon la revendication 8, **caractérisé en ce que** les techniques de diagnostic sont intégrés dans l'étude de l'installation.

10. Système de planification assisté par ordinateur pour mettre en oeuvre le procédé selon la revendication 1 ou l'une des revendications 2 à 9, comportant un ordinateur comportant une unité centrale, des mémoires de travail, de programme et de données et des moyens pour la génération de codes, **caractérisé en ce qu'**il existe des moyens pour former des objets de la technologie des procédés industriels et que les objets formés de la technologie des procédés industriels peuvent être traités dans un système de planification de telle façon qu'il est formé des modèles imbriqués qui consistent en la commande et/ou la régulation et/ou la simulation, y compris l'analyse des perturbations et les modèles de processus, pour lesquels l'ordinateur a accès de la même manière à une bibliothèque (11) de types.de composants de la technologie des procédés industriels et à une définition (13) des éléments de l'installation concrète (12).

11. Système de planification selon la revendication 10, **caractérisé en ce que** la bibliothèque de composants (11) est une partie de la mémoire de données.

12. Système de planification selon la revendication 11, **caractérisé en ce que** les types de composants de la technologie des procédés industriels forment une structure hiérarchisée.

13. Système de planification selon la revendication 10, **caractérisé en ce que** la bibliothèque (11) des types de composants de la technologie des procédés industriels est structurée par branches.

14. Système de planification selon la revendication 10, **caractérisé en ce que** les types de composants de la technologie des procédés industriels sont définis du point de vue d'un technologue et qu'il existe un rapport direct avec la technique des processus industriels.

15. Système de planification selon la revendication 14, **caractérisé en ce que** le comportement des types de composants de la technologie des procédés industriels sont spécifiés quant à la commande et/ou la régulation, la simulation de processus et l'analyse des perturbations.

16. Système de planification selon la revendication 10, **caractérisé en ce que** la structure d'une installation concrète (12) est réalisée par instanciation de types de composants de la technologie des procédés industriels.

17. Système de planification selon la revendication 10, **caractérisé en ce que** les moyens pour générer des codes sont chargés dans la mémoire de programme de l'ordinateur et travaillent de façon automatisée.

18. Système de planification selon la revendication17, **caractérisé en ce qu'**il est prévu un compilateur CSL (30) qui est utilisé pour générer des codes.
